# EUROPEAN PATENT APPLICATION

(11) **EP 1 300 884 A2**
(43) Date of publication of application: **09.04.2003**
(21) Application number: 02020756.9
(22) Date of filing: 16.09.2002
(51) Int. Cl.: H01L 23/552, H05K 9/00

(54) **Apparatus and method for electromagnetic shielding of a device**

(30) Priority: 05.10.2001 US 972393
(71) Applicant: MOTOROLA, INC., Schaumburg, IL 60196 (US)
(72) Inventor: Wong, Suzanne M., Tempe, AZ 85283 (US); Richardson, Patrick J., Tempe, AZ 85283 (US)
(74) Representative: Treleven, Colin

(57) **Abstract**

An apparatus for shield a device (102) includes a surface (104) where the device (102) is coupled to the surface (104) and the device produces electromagnetic energy (112). At least one grounded pad (106) is coupled to the surface (104) and a finger stock (108) is removably coupled to the grounded pad (106). A conductive heat sink (110) is coupled to the finger stock (108), where the conductive heat sink (110) operates to shield the electromagnetic energy (112) produced by the device (102). A method of shielding electromagnetic energy (112) includes placing at least one grounded pad (106) on a surface (104) and removably coupling a finger stock (108) to the grounded pad (106). Thereafter, coupling a conductive heat sink (110) to the finger stock (108) so that the finger stock (108) restorably compresses such that the conductive heat sink (110) couples to the device (102).

## Description

### Background of the Invention

The performance of electronic products continues to increase at a rapid rate, which raises a concern for the mitigation of electromagnetic interference (EMI) that can result from radiation of high frequency signals from such products. In addition, cost and portability are high-priority design parameters and dispensing with costly, labor-intensive parts as well as controlling weight and size will play an ever-increasing role the development of electronic products.

Since electronic products continue to incorporate faster components operating at higher frequencies, limiting unwanted electromagnetic emissions also continues to become more difficult. A common method of shielding electromagnetic energy emitted by an electronic device is board-level-shielding (BLS). In BLS, a custom-formed metallic box is mounted directly to a printed circuit board (PCB) over an electronic device. The metallic box is grounded directly to the ground plane on the (PCB). The effectiveness of BLS is dependent upon the number of points at which the metallic box connects with the ground plane. A larger number of connection points allow the shielding of higher frequency EMI. However, with more connection points, the space between connections becomes small and thermal cooling of the electronic device becomes problematic. Since, along with EMI shielding, thermal dissipation becomes a critical design factor, it is desirable to accomplish EMI control and temperature management with the same part.

Prior art structures utilize a metallic box structure that is overly complex and must be secured, generally by soldering or a socket, to the PCB over the electronic device. These prior art structures serve to ground a corresponding heat sink structure used for heat dissipation to prevent the heat sink from acting like an antenna and further exacerbating the EMI problem. Such prior art structures suffer from many disadvantages. First, these structures take up valuable PCB real estate while often blocking airflow and reducing the thermal contact between the device and the heat sink. Another disadvantage is that these structures are costly and time-intensive to install and remove, which negatively impacts any device rework. Still another disadvantage is that these type of structures limit PCB layout and routing. Yet another disadvantage is that these structures are inflexible and incapable of supporting new electronic devices of dissimilar height or thickness. Yet another disadvantage is that these structures must be secured to the PCB or other surface, usually by soldering, which makes for increased assembly time and expense.

Accordingly, there is a significant need for an apparatus and method of shielding a device that overcomes the deficiencies of the prior art outlined above.

### Brief Description of the Drawings

Referring to the drawing:
FIG.1 is an isometric of an apparatus for shielding a device in accordance with an embodiment of the invention;
FIG.2 is an isometric of an assembled apparatus for shielding a device according to an embodiment of the invention;
FIG. 3 is an isometric of finger stock according to an embodiment of the invention;
FIG.4 is an isometric of an apparatus for shielding a device according to another embodiment of the invention;
FIG.5 is an isometric of an apparatus for shielding a first device according to an embodiment of the invention;
FIG.6 depicts a cross-section from view 6-6 of FIG.5 according to an embodiment of the invention;
FIG.7 depicts a cross-section of an apparatus for shielding a second device according to an embodiment of the invention;
FIG.8 is a flow chart of an embodiment of the invention; and
FIG.9 is a flow chart of another embodiment of the invention.

It will be appreciated that for simplicity and clarity of illustration, elements shown in the drawing have not necessarily been drawn to scale. For example, the dimensions of some of the elements are exaggerated relative to each other. Further, where considered appropriate, reference numerals have been repeated among the Figures to indicate corresponding elements.

### Description of the Preferred Embodiments

In the following detailed description of exemplary embodiments of the invention, reference is made to the accompanying drawings (where like numbers represent like elements), which form a part hereof, and in which is shown by way of illustration specific exemplary embodiments in which the invention may be practiced. These embodiments are described in sufficient detail to enable those skilled in the art to practice the invention, but other embodiments may be utilized and logical, mechanical, electrical and other changes may be made without departing from the scope of the present invention. The following detailed description is, therefore, not to be taken in a limiting sense, and the scope of the present invention is defined only by the appended claims.

In the following description, numerous specific details are set forth to provide a thorough understanding of the invention. However, it is understood that the invention may be practiced without these specific details. In other instances, well-known circuits, structures and techniques have not been shown in detail in order not to obscure the invention.

In the following description and claims, the terms "coupled" and "connected," along with their derivatives, may be used. It should be understood that these terms are not intended as synonyms for each other. Rather, in particular embodiments, "connected" may be used to indicate that two or more elements are in direct physical or electrical contact. However, "coupled" may also mean that two or more elements are not in direct contact with each other, but yet still co-operate or interact with each other.

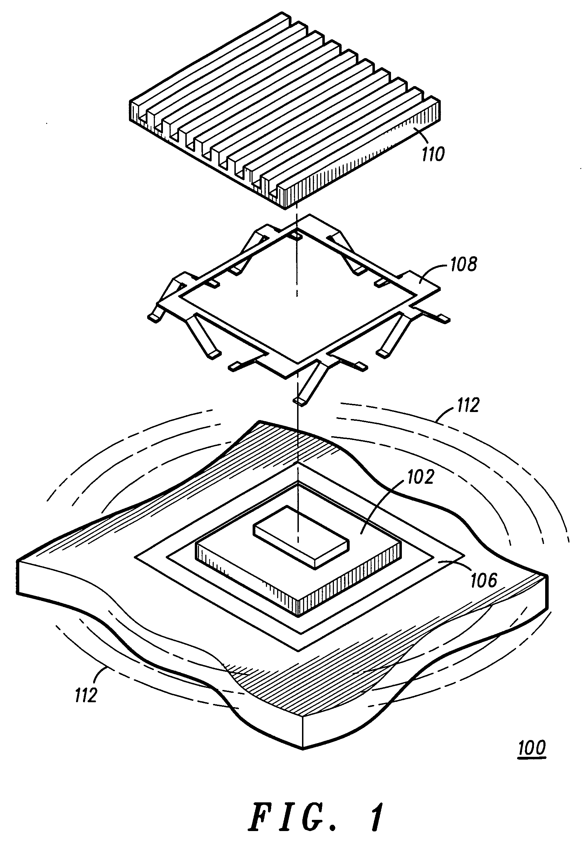

FIG.1 is an isometric of an apparatus 100 for shielding a device in accordance with an embodiment of the invention. As shown in FIG.1, apparatus 100 includes a surface 104, which can be, without limitation, a printed wire board (PWB), printed circuit board, and the like. Coupled to surface 104 is device 102, which can emit electromagnetic energy 112 when operational. Device 102 can be, for example, a processor, cache, clock driver, Radio Frequency (RF) transmitter, any electromagnetic (EM) source, and the like. These examples are not meant to be limiting and any device that produces EM energy is within the scope of the invention. The apparatus of FIG.1 can be part of an electronic device, for example, a computer, and the like. In a preferred embodiment, device 102 is a processor coupled to a PWB.

Electromagnetic (EM) energy 112 produced by device 102 can be harmful to other electronic components in the vicinity of device 102. It is therefore desirable to shield electromagnetic energy 112 emitted by device 102 so as to minimize interference with other electronic devices. Shielding electromagnetic energy 112 can include, without limitation, attenuating EM energy 112, eliminating EM energy 112, absorbing EM energy 112, grounding out EM energy 112 and the like. In order to minimize the shielding requirements of an enclosure of device, such as a case, packaging, and the like, it is desirable to shield electromagnetic energy 112 as close to device 102 as possible. However, device 102 not only produces electromagnetic energy 112, but can also generate heat that needs to be dissipated. Usually a conductive heat sink 110 or other heat dissipation device is coupled to device 102 in order to dissipate heat generated by device 102. Conductive heat sink 110 can be made from any conductive material, for example, copper, aluminum, and the like. Electromagnetic energy 112 generated by device 102 can turn conductive heat sink 110 into an antenna, which further exacerbates the electromagnetic energy 112 problem. Therefore, it is best to ground conductive heat sink 110.

At least one grounded pad 106 is placed on surface 104 in a manner generally surrounding device 102. Grounded pad 106 can be any conductive material, for example, copper, and the like, and can be placed using conventional photolithography etching and other methods known to one skilled in the art. Grounded pad 106 may be grounded through conventional grounding means. In an embodiment of the invention, grounded pad 106 is coupled to the ground plane of a PWB. In a preferred embodiment, grounded pad 106 is placed in the rework keepout area around device 102.

In an embodiment of the invention, finger stock 108 is removably coupled to grounded pad 106. Conductive heat sink 110 can then be coupled to finger stock 108 such that conductive heat sink 110 is also coupled to device 102 and grounded through finger stock 108 and grounded pad 106. In this manner, conductive heat sink 110 and finger stock 108 operate to shield electromagnetic energy 112 produced by device 102.

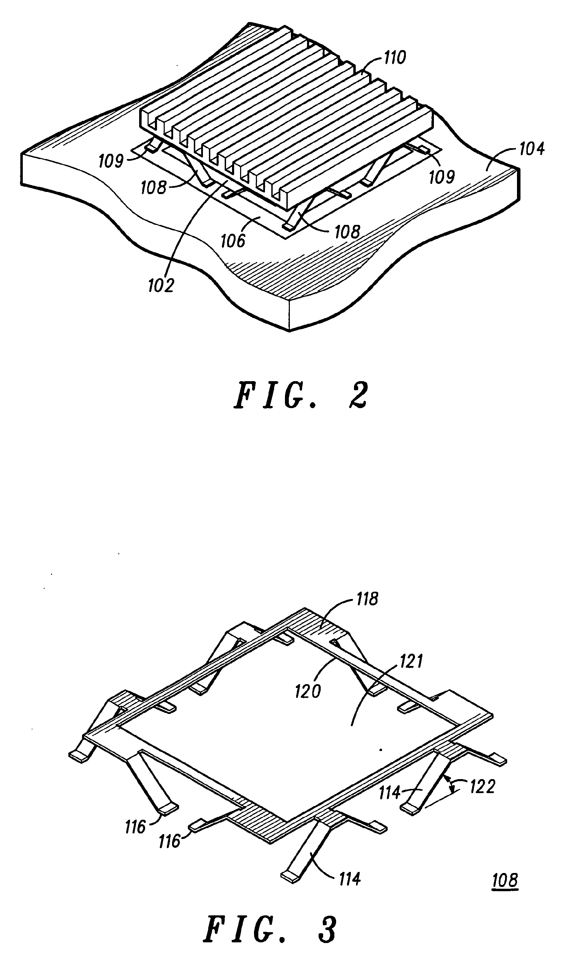

FIG.2 is an isometric of an assembled apparatus for shielding a device according to an embodiment of the invention. Shown in FIG.2 is the assembled apparatus 100 depicted in FIG.1. Finger stock 108 is removably coupled to grounded pad 106. In an embodiment of the invention, when finger stock 108 is removably coupled to grounded pad 106, finger stock 108 is not attached through a physical, chemical, and the like, means such as soldering or a socket, and the like. Removably coupling finger stock 108 to grounded pad 106 can be contrasted with the prior art of physically attaching a metallic box to surface 104 or ground plane of surface 104. When finger stock 108 is removably coupled, there is no attachment means at the interface 109 of finger stock 108 and grounded pad 106 such as soldering, socketing, and the like used to retain finger stock 108 to grounded pad 106. In an embodiment of the invention, finger stock 108 is merely placed on grounded pad 106 with no attachment means. This has the advantage of easy removal of finger stock 108 in the event rework or replacement of device 102 is required. Since finger stock 108 is removably coupled, finger stock 108 can be lifted out of place without the use of special tools, and the like.

As shown in FIG.2, conductive heat sink 110 is coupled to finger stock 108. Conductive heat sink 110 can be secured to surface 104 utilizing conventional means such as screws, clips, and the like. When conductive heat sink 110 is coupled to finger stock 108 and secured to surface 104, finger stock 108 restorably compresses such that conductive heat sink 110 couples to device 102. In effect, finger stock 108 acts like a spring and compresses such that conductive heat sink 110 contains finger stock 108 and can be connected directly to or coupled via one or more conventional thermal pads to device 102. Securing conductive heat sink 110 to surface has the effect of containing and preventing the movement of the restorably compressed finger stock 108. Conductive heat sink 110 can then dissipate heat produced by device 102. Also, conductive heat sink 110 and finger stock 108 are grounded so as to shield electromagnetic energy 112 produced by device 102.

FIG. 3 is an isometric of finger stock 108 according to an embodiment of the invention. As shown in FIG.3, finger stock 108 includes a finger plate 118 with an inner surface 120 defining an empty center portion 121 and a plurality of fingers 114 each with at least one finger pad 116, which are disposed to be removably coupled to grounded pad 106. Plurality of fingers 114 are disposed at an angle 122 to finger plate 118, such that plurality of fingers 114 restorably compress or restorably deflect when finger stock 108 is removably coupled to grounded pad 106 and conductive heat sink 110 is coupled to finger stock 108. Finger stock 108 may be made from any electrically conductive material, for example, copper, aluminum, beryllium copper, stainless steel, phosphor bronze, and the like.

The finger stock 108 depicted in FIG.3 is not meant to be limiting of the invention. Any finger stock 108 that is removably coupled to grounded pads 106 is within the scope of the invention. Finger stock 108 can be designed for each unique application. For example, the number of plurality of fingers 114, the spacing between the plurality of fingers 114, the dimensions of finger stock 108, the amount finger stock 108 restorably compresses, and the like, are all of functions of the type and size of device, the frequency of electromagnetic energy 112 to be shielded, the amount of heat to be dissipated, and the like. The embodiment shown in FIG.3 is comprised of phosphor bronze material of approximately 0.010 inch thickness and is designed to shield (along with conductive heat sink 110) a PowerPC processor operating at approximately 500 Mega Hertz (MHz) on a common mezzanine card. An embodiment of the invention operating in this configuration is shown to improve shielding of device 102 by up to 25 deciBels (dB), which is an improvement factor of 17 over an unshielded device and is a significant improvement over prior art shielding devices. This embodiment is in no way limiting of the invention. One skilled in the art can conceive of variations of an embodiment of the invention to fit a particular application that are within the scope of the invention.

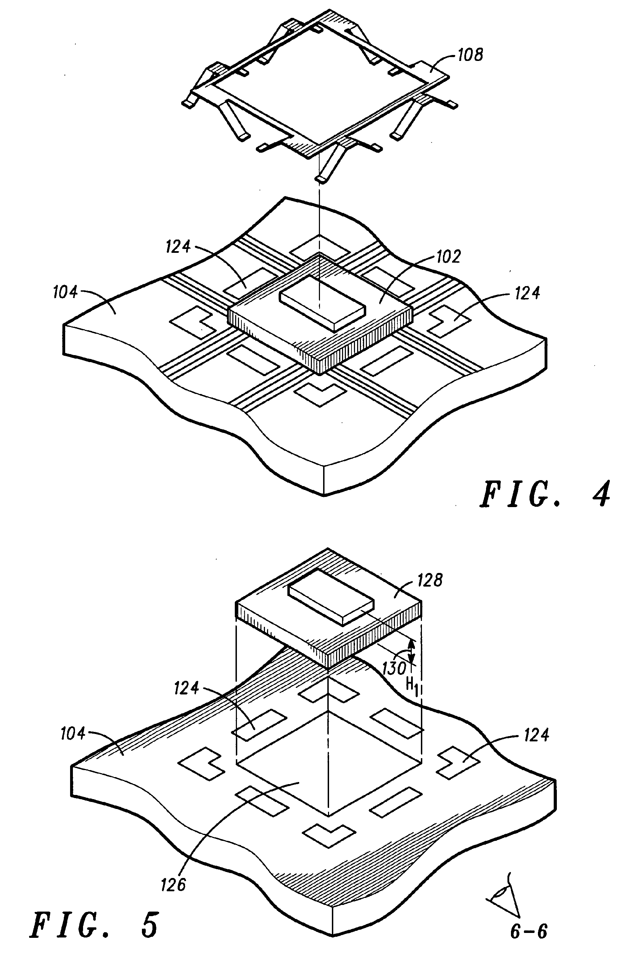

FIG.4 is an isometric of an apparatus for shielding a device 102 according to another embodiment of the invention. As shown in FIG.4, grounded pad 106 from FIG.1 can be a plurality of grounded pads 124. Finger stock 108 can restorably coupled to plurality of grounded pads 124 in the same manner as described above. Each of plurality of fingers 114 described in FIG.3 may be removably coupled to plurality of grounded pads 124. Plurality of grounded pads 124 offers the advantage of using less surface 104 real estate, and allowing more flexibility in routing connections to device between plurality of grounded pads 124 as shown. For example, device can be comprised of a ball grid array (BGA) processor. Nets to and from the BGA can easily be routed between plurality of grounded pads 124 as shown in FIG.4. Pin grid arrays, micro BGA's, and the like, can also be used and are within the scope of the invention. Conductive heat sink 110 (not shown for clarity) can be coupled to finger stock 108 to operate to shield electromagnetic energy 112 produced by device 102 as described above.

FIG.5 is an isometric of an apparatus for shielding a first device 128 according to an embodiment of the invention. As shown in FIG.5, surface 104 comprises device receiving location 126, which is designed to accommodate at least first device 128 having a first height (H₁) 130. First device 128 is designed to be coupled to surface 104 in device receiving location 126. In an embodiment of the invention, device receiving location 126 can accommodate other devices with varying heights. For example, and without limitation, device receiving location 126 may accommodate processors with different heights. In effect, upgraded processors or other devices are capable of being received in the same device receiving location 126 as their predecessors. As an example, first device 128 may be a processor, electromagnetic source, and the like. Plurality of grounded pads 124 generally surround device receiving location 126. In another embodiment, grounded pad 106 surrounds device receiving location 126. In FIG.5, finger stock 108 and conductive heat sink 110 are omitted for clarity.

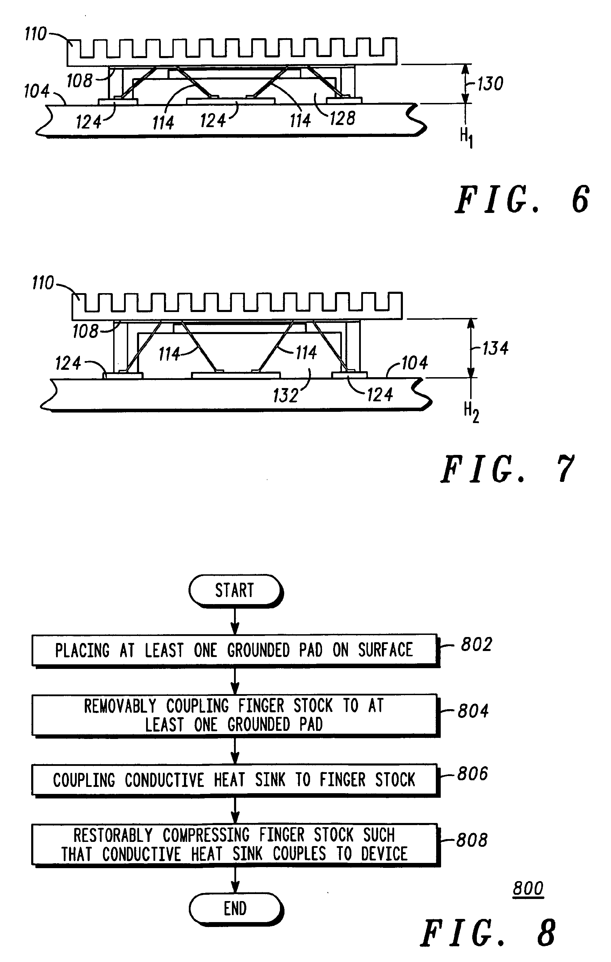

FIG.6 depicts a cross-section from view 6-6 of FIG.5 according to an embodiment of the invention. FIG.6 depicts an assembled apparatus of that shown in FIG.5. As shown in FIG.6, finger stock 108 is removably coupled to plurality of grounded pads 124 and restorably compresses such that conductive heat sink 110 couples to first device 128 at first height 130. Conductive heat sink 110 and finger stock 108 operate to shield electromagnetic energy 112 produced by first device 128.

FIG.7 depicts a cross-section of an apparatus for shielding a second device 132 according to an embodiment of the invention. FIG.7 depicts surface 104 and device receiving location 126 of FIG.5, but with second device 132 having a second height (H₂) 134, where second height 134 is different than first height 130. In effect, FIG.7 is analogous to FIG.6, but with second device 132 having a second height 134 installed instead of first device 128. Second device 132 is designed to be interchangeable with first device 128. Upon replacing first device 128 with second device 132 in device receiving location 126, finger stock 108 restorably compresses such that conductive heat sink 110 couples to second device 132 at second height 134. Conductive heat sink 110 and finger stock 108 operate to shield electromagnetic energy 112 produced by second device 132.

Device receiving location 126 is configured to receive devices of varying heights and finger stock 108 is able to restorably compress to adapt to devices of differing heights. In addition, finger stock 108 is removably coupled to grounded pad 106'or plurality of grounded pads 124. These features offer the advantage of allowing devices of differing heights to be placed in device receiving location with minimal rework and without the need to design new structures for electromagnetic shielding and heat dissipation. In another embodiment of the invention, a different finger stock 108 can be substituted if necessary for wider variations in device 102 height. In this embodiment, there is no need to change the heat sink 110 or layout of surface elements, which is another advantage of the invention.

FIG.8 is a flow chart 800 of an embodiment of the invention. Shown in FIG.8 is a method of shielding electromagnetic energy 112 produced by a device 102 coupled to a surface 104. In step 802, at least one grounded pad 106 is placed on surface 104. Preferably, grounded pad 106 surrounds device 102. In another embodiment, grounded pad 106 comprises a plurality of grounded pads 124.

In step 804, finger stock 108 is removably coupled to at least one grounded pad 106 as described above where no physical attachment means is utilized. In step 806, conductive heat sink 110 is coupled to finger stock 108. In step 808, finger stock is restorably compressed such that conductive heat sink 110 is coupled to device 102. Conductive heat sink 110 is grounded through finger stock 108 and grounded pad 106 and operates to shield electromagnetic energy 112 produced by device 102.

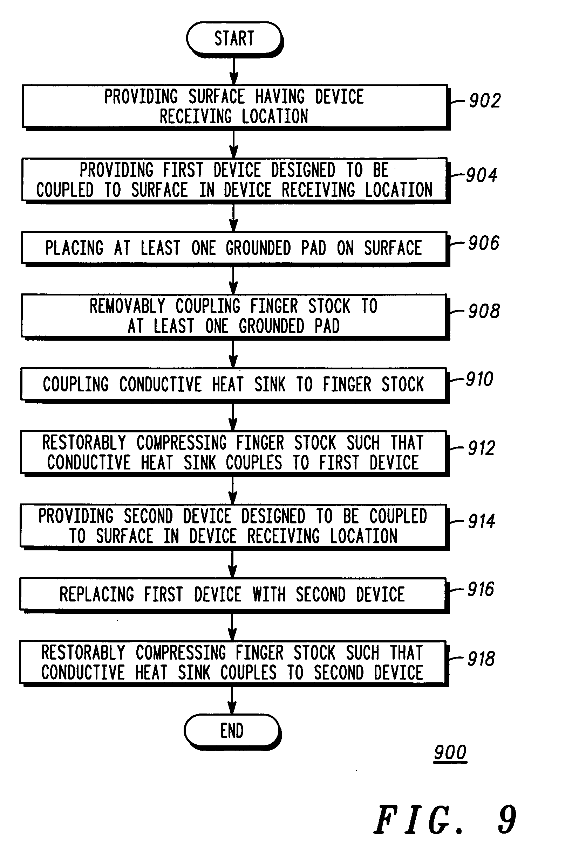

FIG.9 is a flow chart 900 of another embodiment of the invention. Shown in FIG.9 is a method of shielding electromagnetic energy. In step 902, a surface 104 is provided having a device receiving location 126. In step 904, first device 128 having a first height 130 is designed to be coupled to surface 104 in device receiving location 126. In step 906, at least one grounded pad 106 is placed on surface 104. Preferably, grounded pad 106 surrounds device receiving location 126. In another embodiment, grounded pad 106 comprises a plurality of grounded pads 124.

In step 908, finger stock 108 is removably coupled to at least one grounded pad 106 as described above. In step 910, conductive heat sink 110 is coupled to finger stock 108. In step 912, finger stock 108 is restorably compressed such that conductive heat sink 110 is grounded through finger stock 108 and grounded pad 106 and operates to shield electromagnetic energy 112 produced by first device 128.

In step 914, second device 132 having a second height 134 is designed to be coupled to surface 104 in device receiving location 126, where second height 134 is different than first height 130. Second device 132 is designed to be interchangeable with first device 128. In step 916, first device 128 is replaced with second device 132 in device receiving location 126 on surface 104. In step 918, finger stock 108 is restorably compressed such that conductive heat sink 110 is grounded through finger stock 108 and grounded pad 106 and operates to shield electromagnetic energy 112 produced by second device 132.

The apparatus and method of the invention has numerous advantages over the prior art. One advantage is that the apparatus and method of the invention do not take up any additional space on a surface. Another advantage is that the apparatus and method are inexpensive to install and easily removable for rework and upgrading of devices. Yet another advantage is that the apparatus configuration does not significantly limit routing of connections from device to other portions of an electronic product. Still another advantage is that the apparatus and method allow devices of differing height to utilized in an interchangeable device receiving location without any new structure for EM shielding or heat dissipation. Still yet another advantage is that the apparatus does not have to be secured to the surface, but is merely removably coupled, which decreases assembly time and expense, while increasing design flexibility.

While we have shown and described specific embodiments of the present invention, further modifications and improvements will occur to those skilled in the art. It is therefore, to be understood that appended claims are intended to cover all such modifications and changes as fall within the true spirit and scope of the invention.

## Claims

1. An apparatus for shielding a device (102), **characterized by**:
a surface (104), wherein the device is coupled to the surface, and wherein the device produces electromagnetic energy (112);
at least one grounded pad (106) coupled to the surface;
a finger stock (108), wherein the finger stock comprises a plurality of fingers (114), wherein each of the plurality of fingers comprises a finger pad (116), and wherein the finger pad is removably coupled to the at least one grounded pad; and
a conductive heat sink (110) coupled to the finger stock, wherein the conductive heat sink operates to shield the electromagnetic energy produced by the device.

2. The apparatus of claim 1, wherein the finger stock restorably compresses upon coupling to the conductive heat sink such that the conductive heat sink couples to the device.

3. The apparatus of claim 1, wherein the conductive heat sink is grounded through the finger stock and the at least one grounded pad.

4. The apparatus of claim 1, wherein the plurality of fingers are designed to restorably compress upon coupling to the conductive heat sink.

5. An electronic device, **characterized by**:
a printed wire board, wherein an electromagnetic source is coupled to the printed wire board, and wherein the electromagnetic source produces electromagnetic energy;
at least one grounded pad (106) coupled to the printed wire board;
a finger stock (108), wherein the finger stock comprises a plurality of fingers (114), wherein each of the plurality of fingers comprises a finger pad (106), and wherein the finger pad is removably coupled to the at least one grounded pad; and
a conductive heat sink (110) coupled to the finger stock, wherein the conductive heat sink operates to shield the electromagnetic energy produced by the electromagnetic source.

6. A computer, **characterized by**:
a device coupled to a printed wire board, wherein the device produces electromagnetic energy (112);
at least one grounded pad 106) coupled to the printed wire board;
a finger stock (108), wherein the finger stock comprises a plurality of fingers (114), wherein each of the plurality of fingers comprises a finger pad (116), and wherein the finger pad is removably coupled to the at least one grounded pad; and
a conductive heat sink (110) coupled to the finger stock, wherein the conductive heat sink operates to shield the electromagnetic energy produced by the device.

7. An apparatus, **characterized by**:
a surface 104) having a device receiving location;
a first device (128) having a first height designed to be coupled to the surface in the device receiving location;
at least one grounded pad coupled to the surface;
a finger stock, wherein the finger stock comprises a plurality of fingers, wherein each of the plurality of fingers comprises a finger pad, and wherein the finger pad is removably coupled to the at least one grounded pad; and
a conductive heat sink coupled to the finger stock, wherein the finger stock restorably compresses such that the conductive heat sink couples to the first device at the first height, and wherein the conductive heat sink operates to shield electromagnetic energy produced by the first device.

8. A method of shielding electromagnetic energy produced by a device coupled to a surface **characterized by**:
placing at least one grounded pad on the surface;
removably coupling a finger stock to the at least one grounded pad, wherein the finger stock comprises a plurality of fingers, wherein each of the plurality of fingers comprises a finger pad, and wherein the finger pad is removably coupled to the at least one grounded pad; and
coupling a conductive heat sink to the finger stock.

9. A method of shielding electromagnetic energy **characterized by**:
providing a surface having a device receiving location;
providing a first device having a first height designed to be coupled to the surface in the device receiving location;
placing at least one grounded pad on the surface;
removably coupling a finger stock to the at least one grounded pad, wherein the finger stock comprises a plurality of fingers, wherein each of the plurality of fingers comprises a finger pad, and wherein the finger pad is removably coupled to the at least one grounded pad;
coupling a conductive heat sink to the finger stock; and
restorably compressing the finger stock such that the conductive heat sink couples to the first device at the first height.

10. The method of claim 9, further **characterized by**:
providing a second device having a second height designed to be coupled to the surface in the device receiving location and designed to be interchangeable with the first device, wherein the second height is different than the first height;
replacing the first device with the second device; and
restorably compressing the finger stock such that the conductive heat sink couples to the second device at the second height.
